# EUROPÄISCHE PATENTSCHRIFT

(11) **EP 2 235 552 B1**
(45) Veröffentlichungstag und Bekanntmachung des Hinweises auf die Patenterteilung: **23.03.2011**
(21) Anmeldenummer: 08871507.3
(22) Anmeldetag: 26.11.2008
(51) Int. Cl.: G01R 33/02, G01R 33/00, G01D 11/24, G01P 3/42, B29C 45/14

(54) **VERFAHREN UND VORRICHTUNG ZUR HERSTELLUNG EINES MAGNETFELDSENSORS**
METHOD AND DEVICE FOR PRODUCING A MAGNETIC FIELD SENSOR
PROCÉDÉ ET DISPOSITIF DE FABRICATION D'UN CAPTEUR DE CHAMP MAGNÉTIQUE

(30) Priorität: 21.01.2008 DE 102008005315
(43) Veröffentlichungstag der Anmeldung: 06.10.2010
(73) Patentinhaber: Robert Bosch GmbH, 70442 Stuttgart (DE)
(72) Erfinder: GOETZ, Rolf, 99894 Friedrichroda (DE); SCHULZE, Steffen, 99817 Eisenach (DE); MATTHIE, Daniel, 99817 Eisenach (DE); KNY, Markus, 98634 Wasungen (DE); WEISHAEUTEL, Frank, 99869 Wangenheim (DE)
(86) Internationale Anmeldenummer: PCT/EP2008/066224
(87) Internationale Veröffentlichungsnummer: WO 2009/092478

(56) Entgegenhaltungen:
- EP-A1- 0 694 766
- DE-A1- 4 228 888
- FR-A1- 2 576 245
- FR-A1- 2 864 700
- US-A- 5 032 790

## Beschreibung

### Stand der Technik

Die Erfindung geht aus von einem Verfahren und einer Vorrichtung zur Herstellung eines Magnetfeldsensors nach der Gattung der unabhängigen Ansprüche. Gegenstand der vorliegenden Erfindung ist auch ein nach dem vorgeschlagenen Verfahren und/oder mit Hilfe der beanspruchten Vorrichtung hergestellter Magnetfeldsensor.

Aus der DE 101 29 222 A1 sind bereits ein Magnetfeldsensor und ein Verfahren zu seiner Herstellung durch Umspritzen eines ein Sensorelement enthaltenden Trägers bekannt. Das Sensorelement sitzt hierbei auf einem Trägerelement aus Metall und ist in einer festgelegten Position zu einem rotierenden Geberelement durch eine Umspritzung aus Kunststoff fixiert. Die Position des Sensorelementes ergibt sich durch einen Anschlag, welcher den Abstand zwischen dem Sensor und dem Encoder definiert, wobei weder dieser Abstand noch die Winkelposition des Sensors zum Encoder veränderbar sind.

Weiterhin ist in der DE-Patentanmeldung 10 2006 050 177.2 bereits ein als Drehzahl- und/oder Drehrichtungssensor für ein Fahrzeugrad ausgebildeter Magnetfeldsensor vorgeschlagen worden, bei dem ein magnetfeldempfindliches Sensorelement zusammen mit seinem Träger mit Kunststoff umspritzt sind. Die Kunststoffumspritzung umschließt dabei auch das Ende eines Anschlusskabels und ist so gestaltet, dass der Spritzverguss eine Anschlusslasche mit einer Befestigungsbuchse für die Montage des Sensors ausbildet. Hierbei kann die Winkelposition des Sensors gegenüber einem Geberrad durch Verdrehen um die Mittelachse der Befestigungsbuchse in engen Grenzen justiert, die axiale Positionierung des Sensors jedoch nicht verändert werden.

Die Druckschrift US 5,032,790 offenbart einen passiven magnetischen Geschwindigkeitssensor. Der Sensor weist eine Spule, einen Magnetkern und Kontaktanschlüsse auf.

Die Druckschrift FR 2576245 offenbart ein Verfahren zum Beschichten eines länglichen Sensors und eine Gießvorrichtung zur Durchführung des genannten Verfahrens.

### Offenbarung der Erfindung

Ein nach dem vorgeschlagenen Verfahren und/oder' mittels der erfindungsgemäßen Vorrichtung hergestellter Sensor hat demgegenüber den Vorteil, dass entsprechend den jeweiligen Einbauverhältnissen des Sensors sowohl die Längsposition als auch die Winkelposition der Befestigungslasche und somit des Sensors zu einem Geberelement veränderbar sind, so dass Sensoren für unterschiedliche Einbausituationen ohne Wechsel von Werkzeugeinsätzen oder gar des gesamten Spritzgießwerkzeugs hergestellt werden können.

Besonders vorteilhaft ist es hierbei, wenn ein in einem ersten Spritzvorgang hergestelltes kernartiges Einlegeteil in einem zweiten Spritzvorgang in einem in dem Spritzgießwerkzeug längsverschiebbaren und/oder verdrehbaren Werkzeugeinsatz gehalten wird. Auf diese Weise kann das Einlegeteil vor dem zweiten Spritzvorgang exakt und ohne Schwierigkeiten positioniert und die Befestigungslasche in der vorgegebenen Längs- und Winkelposition angespritzt werden. Zweckmäßigerweise ist hierbei das kernartige Einlegeteil im Wesentlichen zylindrisch geformt und in einer

Bohrung des Werkzeugeinsatzes positioniert, wodurch die Einbringung und Ausrichtung des Einlegeteils mit der elektrischen Baugruppe weiter vereinfacht wird.

Hinsichtlich der Gestaltung der erfindungsgemäßen Vorrichtung zur Herstellung eines Magnetfeldsensors mit einer die Einbaulage des Sensors bestimmenden Befestigungslasche ist es besonders vorteilhaft, wenn zum Anspritzen der Befestigungslasche in einem Spritzgießwerkzeug ein Werkzeugeinsatz längsverschiebbar und/oder verdrehbar angeordnet ist zur Aufnahme eines kernartigen, in einem vorausgegangenen Arbeitsschritt hergestellten und die elektrische Baugruppe enthaltenden Einlegeteils. So können auf der gleichen Grundbauform basierende Sensoren für unterschiedliche Einbauverhältnisse mit verschiedenen Längs- und Winkelpositionen zu einem Geberelement ohne kostspielige Veränderungen an dem Spritzgießwerkzeug hergestellt werden.

Der Werkzeugeinsatz ist zweckmäßigerweise in dem Spritzgießwerkzeug kontinuierlich verschiebbar und arretierbar in unterschiedliche Längs- und/oder Winkelpositionen. Vorzugsweise sind hierbei sowohl der Werkzeugeinsatz wie auch das kernartige Einlegeteil mit der elektrischen Baugruppe zylindrisch, beziehungsweise hohlzylindrisch ausgebildet, wodurch sowohl die Einbringung als auch die Positionierung erleichtert werden.

Weitere Einzelheiten und vorteilhafte Ausgestaltungen der Erfindung ergeben sich aus den Unteransprüchen und der Beschreibung eines Ausführungsbeispieles.

### Kurze Beschreibung der Zeichnungen

Ausführungsbeispiele eines erfindungsgemäß hergestellten Magnetfeldsensors und einer Vorrichtung zu seiner Herstellung sind in den Zeichnungen dargestellt und in der nachfolgenden Beschreibung näher erläutert.

Es zeigen
- Figur 1: eine schematisierte Darstellung eines erfindungsgemäßen Magnetfeldsensors,
- Figur 2: eine perspektivische Darstellung eines kernartigen, die elektronische Baugruppe aufnehmenden Einlegeteils mit Anschlusskabel als vorgefertigtes Bauteil des Magnetfeldsensors,
- Figur 3: eine perspektivische Darstellung eines fertigen Magnetfeldsensors,
- Figur 4: eine perspektivische Darstellung des Unterteils eines Spritzgießwerkzeuges mit eingefügtem Werkzeugeinsatz für die Aufnahme des Einlegeteils gemäß Figur 1,
- Figur 5: einen Schnitt durch das Spritzgießwerkzeug mit einer Darstellung eines fertigen Magnetfeldsensors und
- Figur 6: einen Schnitt entsprechend der Linie VI-VI in Figur 5.

### Ausführungsform der Erfindung

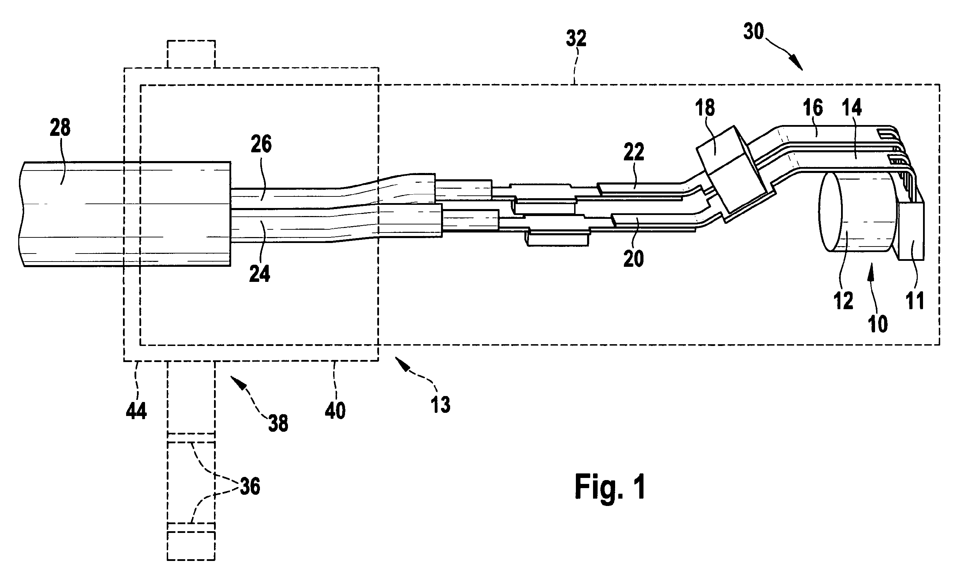

In Figur 1 ist die gemäß dem vorgeschlagenen Verfahren mit thermoplastischem Kunststoff zu umspritzende elektrische Baugruppe 10 eines Magnetfeldsensors 13 in der Ausführung als Drehzahlsensor zur Erfassung der Raddrehung eines Kraftfahrzeuges dargestellt. Diese enthält einen IC-Baustein 11 mit einem Sensorelement und einer integrierten Schaltung für die Aufbereitung der Messsignale und die Messwertausgabe. Das Magnetfeld zur Erzeugung der Messsignale wird von einem zylindrischen Permanentmagneten 12 bereitgestellt, welcher unmittelbar benachbart zu dem IC-Baustein 11 angeordnet ist. Zwei Leiterbahnen 14 und 16 der integrierten Schaltung 11 sind zum Abbau von Signalspitzen durch einen Kondensator 18 überbrückt und durch Crimpverbindungen 20 und 22 mit Anschlussleitungen 24 und 26 eines Kabels 28 verbunden, dessen vorderes Ende zusammen mit den Leitungen 24 und 26, dem Kondensator 18, dem Permanentmagneten 12 und der integrierten Schaltung 11 zum fertigen, hinsichtlich Aufbau und Wirkungsweise bekannten Magnetfeldsensor mit Kunststoff umspritzt wird. Die einzelnen Teile der Kunststoffumspritzung sind in Figur 1 durch gestrichelte Linien angedeutet und in den folgenden Figuren näher erläutert.

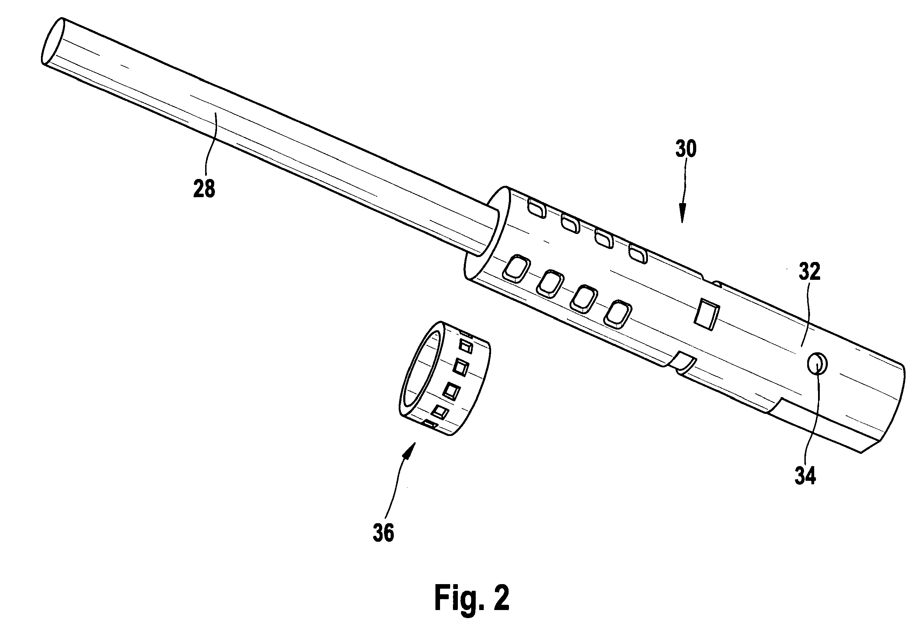

Figur 2 zeigt in perspektivischer Darstellung ein kernartiges Einlegeteil 30, welches in einer zylindrischen Umspritzung 32 die mit dem Anschlusskabel 28 verbundene elektrische Baugruppe 10 enthält. Eine Bohrung 34 markiert dabei die Position des IC-Bausteins 11 der elektrischen Baugruppe 10 als sensierendes Element, nach welcher der Magnetfeldsensor 13 bei der Montage ausgerichtet wird. Weiterhin ist in Figur 2 noch eine metallische Buchse 36 in der Position dargestellt, in der sie im zweiten Spritzvorgang mit dem Einlegeteil 30 verbunden wird.

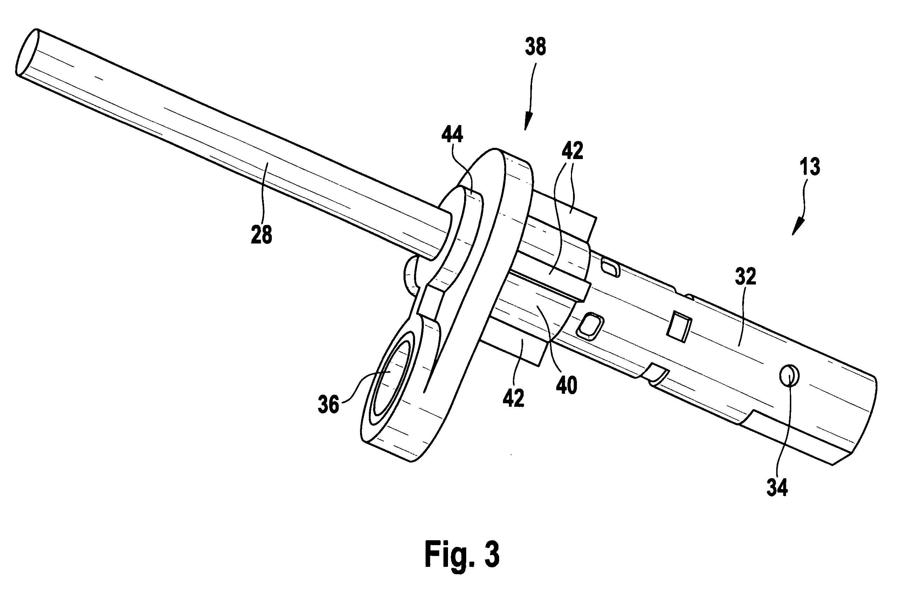

Figur 3 zeigt ebenfalls in perspektivischer Darstellung den fertigen Magnetfeldsensor 30 nach dem zweiten Spritzvorgang, in welchem eine Befestigungslasche 38 in einer vorgebbaren Längs- und Winkelposition an das kernartige Einlegeteil 30 angespritzt wurde. In diesem zweiten Spritzvorgang wird das Einlegeteil 30 mittels der Bohrung 34 hinsichtlich der Längs- und der Winkelposition in einem weiter unten erläuterten Spritzgießwerkzeug positioniert, in welchem dann die Befestigungslasche 38 in der für die spätere Montage des Sensors 13 vorgegebene Position angespritzt wird.

In die Befestigungslasche 38 ist die aus Figur 2 ersichtliche metallische Buchse 36 eingespritzt, um die Stabilität der Sensorbefestigung zu erhöhen. Außerdem ist an die Befestigungslasche eine die Kunststoffumspritzung 32 des Einlegeteils 30 teilweise überdeckende Zentrierhülse 40 angespritzt, welche vier gleichmäßig am Umfang der Zentrierhülse verteilte Rippen 42 aufweist, mit denen der gesamte Sensor 13 bei der Montage zentriert wird. Weiterhin ist an die Befestigungslasche 38, der Zentrierhülse 40 gegenüberliegend, noch ein Ringflansch 44 angespritzt, welcher das Anschlusskabel 38 umgreift und den Übergang vom Kabel zu dem Einlegeteil 30 stabilisiert.

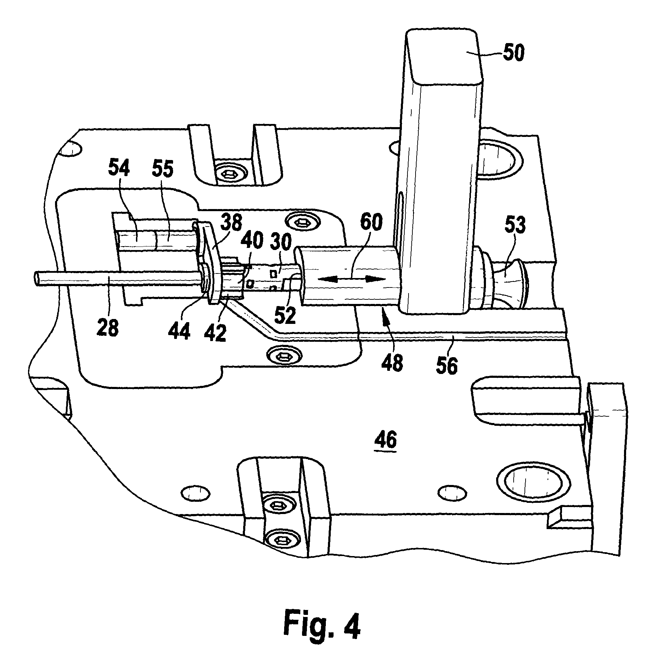

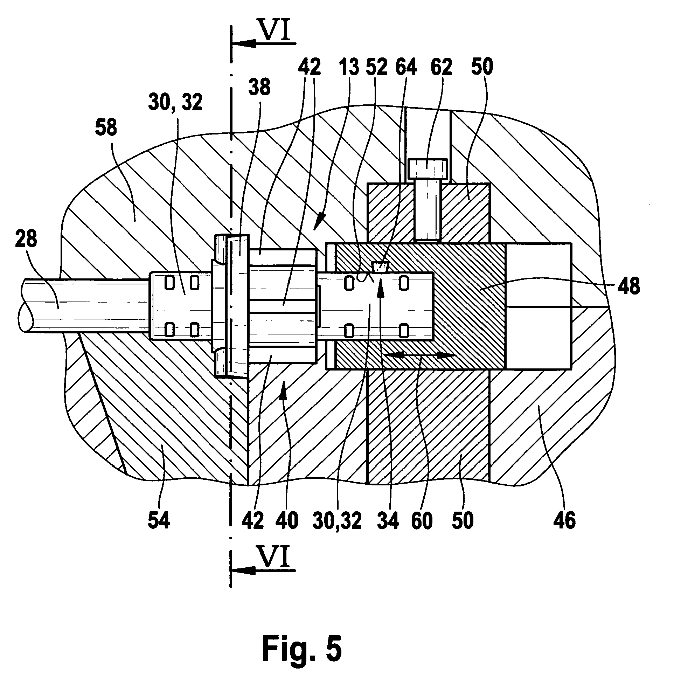

In Figur 4 ist perspektivisch das Unterteil 46 eines Spritzgießwerkzeuges mit einem Werkzeugeinsatz 48 für die Aufnahme des Einlegeteils 30 dargestellt. Der Werkzeugeinsatz 48 ist insgesamt zylindrisch geformt und besitzt eine zylindrische Bohrung 52 für die Aufnahme des ebenfalls zylindrischen Einlegeteils 30. Der Werkzeugeinsatz ist im Spritzgießwerkzeug und in einem Träger 50 kontinuierlich in beliebige Stellungen längsverschiebbar und verdrehbar und danach in der eingestellten Position arretierbar, wie dies weiter unten insbesondere an Hand der Figur 5 noch näher erläutert wird. Für die Einstellung ist bei dieser Ausführung ein Handgriff 53 angeformt.

Nach der Positionierung des Trägers 50 im Unterteil 46 des Spritzgießwerkzeuges wird das Einlegeteil 30 mit dem Anschlusskabel 28 in einer durch die spätere Montage vorgegebenen Funktionslänge und Winkelposition in dem Spritzgießwerkzeug 46 und in dem Werkzeugeinsatz 48 positioniert und der Werkzeugeinsatz seinerseits in dem Spritzgießwerkzeug arretiert. Die in die Befestigungslasche 38 einzuspritzende Buchse 36 wird mittels eines Schiebers 54 und eines Dorns 55 in ihre aus den Figuren 2 und 3 ersichtliche Position im Bereich der anzuspritzenden Befestigungslasche 38 eingeschoben und der Schieber 54 anschließend wieder zurückgefahren. Die Zuführung der Kunststoffmasse für das Anspritzen der Befestigungslasche 38 erfolgt über einen Kanal 56.

Die Figur 4 zeigt das geöffnete Spritzgießwerkzeug nach dem Spritzvorgang, wobei sich der Sensor noch im Unterteil 46 der Spritzgießform befindet. Die Befestigungslasche 38 ist in dieser Darstellung bereits an das Einlegeteil 30 angespritzt, so dass der fertige Magnetfeldsensor 13 ausgeworfen werden kann.

Figur 5 zeigt einen Schnitt durch das Spritzgießwerkzeug mit dem Unterteil 46, dem als Schrägschieber ausgebildeten Schieber 54 und einem Oberteil 58. Im Unterteil 46 und im Oberteil 58 sitzt jeweils mit einem Teil seiner Ausdehnung der Träger 50, in dem der Werkzeugeinsatz 48 längsverschiebbar entsprechend dem Pfeil 60 und um seine Mittelachse verdrehbar gehalten ist. Die Festlegung des Werkzeugeinsatzes 48 in dem Träger 50 erfolgt durch ein

Arretierungsteil 62. In die Bohrung 52 im Werkzeugeinsatz 48 ist das Einlegeteil 30 in seiner vorgegebenen Winkellage bis zum Ende in die Bohrung 52 eingeschoben. Die Arretierung des Einlegeteils erfolgt durch einen Fixierungsstift 64, welcher die beim Einschieben vorgegebene Winkelposition sichert und das Einlegeteil zusammen mit dem Anschlusskabel 28 in seiner Position hält, wobei der Fixierungsstift in die Markierungsbohrung 34 in dem Einlegeteil 30 eingreift und die durch die Lage des IC-Bausteins 11 vorgegebene Position sichert.

Die unterschiedlichen Positionierungsmöglichkeiten der Befestigungslasche 38 sind bei einem Vergleich der Figuren 3 und 5 erkennbar. Während in Figur 3 die Befestigungslasche 38 an dem kabelseitigen Ende des Einlegeteils 30 angeordnet ist sitzt sie bei der Anordnung gemäß Figur 5 weiter in der Mitte des Einlegeteils 30 und bestimmt so eine andere Funktionslänge des Sensors. Die Positionierung ergibt sich durch die Längsverschiebung entsprechend dem Pfeil 60 und gegebenenfalls eine Verdrehung des Werkzeugeinsatzes 48, wobei das Einlegeteil 30 jeweils vollständig in die Bohrung 52 eingeschoben ist. Die Position der Befestigungslasche 38 im Spritzgießwerkzeug ist fest vorgegeben.

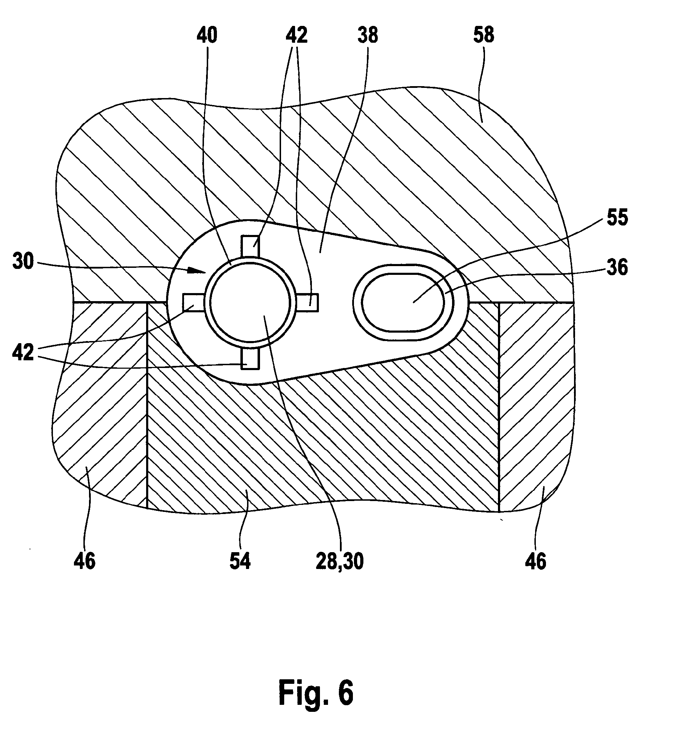

Figur 6 zeigt einen Schnitt durch das Spritzgießwerkzeug im Bereich der Schnittlinie VI-VI in Figur 5. Aus dieser Darstellung ist nochmals die Gestaltung der Befestigungslasche 38 für das Einlegeteil 30 erkennbar, ebenso wie die Lage der Befestigungsbuchse 36, welche in diesem Fall oval ausgebildet ist, um eine gewisse Befestigungstoleranz bei der Montage des Sensors zu erhalten. Im Übrigen sind in Figur 6 gleiche Teile mit den gleichen Bezugszeichen versehen wie in den vorhergehenden Darstellungen.

## Patentansprüche

1. Verfahren zur Herstellung eines Magnetfeldsensors (13), insbesondere eines Drehzahl- und/oder Drehrichtungssensors für die Raddrehung oder für den Triebstrang eines Kraftfahrzeuges, wobei eine elektrische Baugruppe (10),die einen IC-Baustein (11) mit einem Sensorelement und einer integrierten Schaltung für die Aufbereitung der Messsignale und die Messwertausgabe enthält, und das Ende eines Anschlusskabels (28) durch Spritzgießen mit Kunststoff umhüllt und eine Befestigungslasche (38) angespritzt werden, **dadurch gekennzeichnet, dass** nach einem ersten Spritzvorgang, in dem die elektrische Baugruppe (10) und das Anschlusskabel (28) mit einem kernartigen ersten Verguss (30, 32) umspritzt werden, in einem zweiten Spritzvorgang eine Befestigungslasche (38) in einer vorgebbaren Längs- und/oder Winkelposition an das kernartige Einlegeteil (30) angespritzt wird, wobei das kernartige Einlegeteil (30) längsverschiebbar und/oder verdrehbar in dem Spritzgießwerkzeug (46,58) gehalten wird.

2. Verfahren nach Anspruch 1, **dadurch gekennzeichnet, dass** das kernartige Einlegeteil (30) im zweiten Spritzvorgang in einem in dem Spritzgießwerkzeug (46,58) längsverschiebbaren und/oder verdrehbaren Werkzeugeinsatz (48) gehalten wird.

3. Verfahren nach Anspruch 1 oder 2, **dadurch gekennzeichnet, dass** das kernartige Einlegeteil (30) im Wesentlichen zylindrisch geformt ist und in einer Bohrung (58) des Werkzeugeinsatzes (48) positioniert wird.

4. Verfahren nach einem der vorhergehenden Ansprüche, **dadurch gekennzeichnet, dass** in dem zweiten Spritzvorgang eine vorzugsweise metallische Buchse (36) in die Befestigungslasche (38) eingespritzt wird.

5. Verfahren nach einem der vorhergehenden Ansprüche, **dadurch gekennzeichnet, dass** in dem zweiten Spritzvorgang eine das kernartige Einlegeteil (30) umgreifende Zentrierhülse (40) einteilig an die Befestigungslasche (38) angespritzt wird.

6. Vorrichtung Konfiguriert zur Durchführung des Verfahrens nach einem der Ansprüche 1-5 zur Herstellung eines Magnetfeldsensors (13) mit einer die Einbaulage des Magnetfeldsensors bestimmenden Befestigungslasche (38), insbesondere eines Drehzahl- und/oder Drehrichtungssensors für die Raddrehung oder für den Triebstrang eines Kraftfahrzeuges, **dadurch gekennzeichnet, dass** zum Anspritzen der Befestigungslasche (38) mit Einspritzen einer metallischen Buchse an ein kernartiges Einlegeteil (30) in einem Spritzgießwerkzeug (46, 58) ein Werkzeugeinsatz (48) längsverschiebbar und/oder verdrehbar angeordnet ist zur Aufnahme des kernartigen, eine elektrische Baugruppe (10) enthaltenden Einlegeteils(30), wobei das kernartige Einlegeteil (30) in einer zylindrischen Umspritzung (32) die mit dem Anschlusskabel (28) verbundene elektronische Baugruppe (10) enthält, die einen IC-Baustein (11) mit einem Sensorelement und einer integrierten Schaltung für die Aufbereitung der Messsignale und die Messwertausgabe enthält.

7. Vorrichtung nach Anspruch 6, **dadurch gekennzeichnet, dass** der Werkzeugeinsatz (48) in dem Spritzgießwerkzeug (46,58) in kontinuierlich veränderbare Längs- und/oder Winkelpositionen verschiebbar und dort arretierbar ist.

8. Vorrichtung nach Anspruch 6 oder 7, **dadurch gekennzeichnet, dass** der Werkzeugeinsatz (48) eine Bohrung (58) zur Aufnahme des kernartigen Einlegeteils (30) in unterschiedlichen Einschubpositionen aufweist.

9. Vorrichtung nach einem der Ansprüche 6 bis 8, **dadurch gekennzeichnet, dass** der Werkzeugeinsatz (48) im Wesentlichen zylinderförmig ausgebildet und axial in dem Spritzgießwerkzeug (46,58) verschiebbar ist.

10. Vorrichtung nach einem der Ansprüche 6 bis 9, **dadurch gekennzeichnet, dass** das kernartige Einlegeteil (30) eine Markierungsbohrung (34) entsprechend der Lage der darin vergossenen elektrischen Baugruppe (10) aufweist.

11. Vorrichtung nach einem der Ansprüche 6 bis 10, **dadurch gekennzeichnet, dass** in dem Spritzgießwerkzeug (46,58) axial versetzt zu dem Werkzeugeinsatz (48) für die Halterung des kernartigen Einlegeteils (30) ein Schrägschieber (54) für die Zuführung einer vorzugsweise metallischen, in die Lasche (38) einzuspritzenden Buchse (36) angeordnet ist.

## Claims

1. Method for producing a magnetic field sensor (13), in particular a rotational speed and/or rotational direction sensor for the wheel rotation or for the drive train of a motor vehicle, an electrical subassembly (10) containing an IC chip (11) with a sensor element and an integrated circuit for conditioning the measurement signals and outputting the measured values, and the end of a connection cable (28) being encased with plastic by means of injection moulding, and a fastening lug (38) being injection-moulded on, **characterized in that**, after a first injection-moulding operation in which the electrical subassembly (10) and the connection cable (28) are encapsulated with a core-like first encapsulation (30, 32), a fastening lug (38) is injection-moulded onto the core-like insert part (30) in a predefinable longitudinal and/or angular position in a second injection-moulding operation, the core-like insert part (30) being held in the injection mould (46, 58) in a longitudinally displaceable and/or rotatable manner.

2. Method according to Claim 1, **characterized in that**, in the second injection-moulding operation, the core-like insert part (30) is held in a tool insert (48) which can be longitudinally displaced and/or rotated in the injection mould (46, 58).

3. Method according to Claim 1 or 2, **characterized in that** the core-like insert part (30) is substantially cylindrical and is positioned in a hole (58) in the tool insert (48).

4. Method according to one of the preceding claims, **characterized in that** a preferably metal bushing (36) is injected into the fastening lug (38) in the second injection-moulding operation.

5. Method according to one of the preceding claims, **characterized in that**, in the second injection-moulding operation, a centring sleeve (40) which engages around the core-like insert part (30) is injection-moulded onto the fastening lug (38) in one piece.

6. Device configured to carry out the method according to one of Claims 1-5 for producing a magnetic field sensor (13) having a fastening lug (38) which determines the installation position of the magnetic field sensor, in particular a rotational speed and/or rotational direction sensor for the wheel rotation or for the drive train of a motor vehicle, **characterized in that**, in order to injection-mould the fastening lug (38) onto a core-like insert part (30) in an injection mould (46, 58) with injection of a metal bushing, a tool insert (48) is arranged in a longitudinally displaceable and/or rotatable manner in order to accommodate the core-like insert part (30) containing an electrical subassembly (10), the core-like insert part (30) containing, in a cylindrical encapsulation (32), the electronic subassembly (10) which is connected to the connection cable (28) and contains an IC chip (11) with a sensor element and an integrated circuit for conditioning the measurement signals and outputting the measured values.

7. Device according to Claim 6, **characterized in that** the tool insert (48) can be displaced in the injection mould (46, 58) in continuously variable longitudinal and/or angular positions and can be locked there.

8. Device according to Claim 6 or 7, **characterized in that** the tool insert (48) has a hole (58) for accommodating the core-like insert part (30) in different insertion positions.

9. Device according to one of Claims 6 to 8, **characterized in that** the tool insert (48) is substantially cylindrical and can be axially displaced in the injection mould (46, 58).

10. Device according to one of Claims 6 to 9, **characterized in that** the core-like insert part (30) has a marking hole (34) in accordance with the position of the electrical subassembly (10) encapsulated therein.

11. Device according to one of Claims 6 to 10, **characterized in that** an inclined sliding carriage (54) for supplying a preferably metal bushing (36) to be injected into the lug (38) is arranged in the injection mould (46, 58) with an axial offset with respect to the tool insert (48) for holding the core-like insert part (30).

## Revendications

1. Procédé de fabrication d'un détecteur (13) de champ magnétique, en particulier d'un détecteur de vitesse de rotation et/ou de sens de rotation pour les roues ou le train d'entraînement d'un véhicule automobile,
dans lequel un ensemble électrique (10) qui contient un module IC (11) doté d'un élément de détection et d'un circuit intégré qui prépare les signaux de mesure et délivre les valeurs de mesure et qui contient l'extrémité d'un câble de raccordement (28) est enveloppé de matière synthétique par moulage par injection, une patte de fixation (38) étant formée par injection,
**caractérisé en ce que**
après une première opération d'injection dans laquelle l'ensemble électrique (10) et le câble de raccordement (28) sont enrobés par injection dans un premier moulage (30, 32) de type noyau, une patte de fixation (38) disposée en une position longitudinale et/ou angulaire prédéterminable est formée par injection sur la pièce d'insertion (30) en forme de noyau dans une deuxième opération d'injection, la pièce d'insertion (30) en forme de noyau étant maintenue à coulissement longitudinal et/ou à rotation dans l'outil (46, 58) de moulage par injection.

2. Procédé selon la revendication 1, **caractérisé en ce qu'**au cours de la deuxième opération d'injection, la pièce d'insertion (30) en forme de noyau est maintenue dans une garniture d'outil (48) apte à coulisser longitudinalement et/ou à tourner dans l'outil (46, 58) de moulage par injection.

3. Procédé selon les revendications 1 ou 2, **caractérisé en ce que** la pièce d'insertion (30) en forme de noyau a une forme essentiellement cylindrique et est placée dans un alésage (58) de la garniture d'outil (48).

4. Procédé selon l'une des revendications précédentes, **caractérisé en ce qu'**une douille (36) de préférence métallique est injectée dans la deuxième opération d'injection dans la patte de fixation (38).

5. Procédé selon l'une des revendications précédentes, **caractérisé en ce que** lors de la deuxième opération d'injection, une douille de centrage (40) qui chevauche la pièce d'insertion (30) en forme de noyau est formée d'un seul tenant par injection sur la patte de fixation (38).

6. Dispositif configuré en vue de l'exécution du procédé selon l'une des revendications 1 à 5, pour la fabrication d'un détecteur (13) de champ magnétique doté d'une patte de fixation (38) qui définit la position de montage du détecteur de champ magnétique, en particulier d'un détecteur de vitesse de rotation et/ou de sens de rotation des roues ou du train d'entraînement d'un véhicule automobile,
**caractérisé en ce que**
pour former par injection la patte de fixation (38) avec injection d'une douille métallique sur une pièce d'insertion (30) en forme de noyau, une garniture d'outil (48) est disposée à coulissement longitudinal et/ou à rotation dans un outil (46, 58) de moulage par injection pour reprendre la pièce d'insertion (30) en forme de noyau qui contient le module électrique (10),
**en ce que** la pièce d'insertion (30) en forme de noyau contient dans un moulage cylindrique (32) obtenu par injection le module électronique (10) relié au câble de raccordement (28) et qui contient un module IC (11) doté d'un élément de détection et d'un circuit intégré qui prépare les signaux de mesure et délivre les valeurs de mesure.

7. Dispositif selon la revendication 6, **caractérisé en ce que** la garniture d'outil (48) peut coulisser dans l'outil (46, 58) de moulage par injection dans des positions longitudinales et/ou angulaires variables en continu et peut y être bloquée.

8. Dispositif selon les revendications 6 ou 7, **caractérisé en ce que** la garniture d'outil (48) présente un alésage (58) qui reprend la pièce d'insertion (30) en forme de noyau en différentes positions d'insertion.

9. Dispositif selon l'une des revendications 6 à 8, **caractérisé en ce que** la garniture d'outil (48) a une configuration essentiellement cylindrique et peut coulisser axialement dans l'outil (46, 58) de moulage par injection.

10. Dispositif selon l'une des revendications 6 à 9, **caractérisé en ce que** la pièce d'insertion (30) en forme de noyau présente un alésage de repérage (34) qui correspond à la position du module électrique (10) qui y est incorporé.

11. Dispositif selon l'une des revendications 6 à 10, **caractérisé en ce qu'**un coulisseau oblique (54) qui amène une douille (36) de préférence métallique qui doit être injectée dans la patte (38) est disposé dans l'outil (46, 58) de moulage par injection en décalage axial par rapport à la garniture d'outil (48) destinée à maintenir la pièce d'insertion (30) en forme de noyau.
